# EUROPÄISCHE PATENTSCHRIFT

(11) **EP 1 032 949 B1**
(45) Veröffentlichungstag und Bekanntmachung des Hinweises auf die Patenterteilung: **19.01.2005**
(21) Anmeldenummer: 98948658.4
(22) Anmeldetag: 23.10.1998
(51) Int. Cl.: H01L 31/032

(54) **HALBLEITERBAUELEMENT, INSBESONDERE EINE SOLARZELLE, SOWIE VERFAHREN ZU DESSEN HERSTELLUNG**
SEMICONDUCTOR ELEMENT, ESPECIALLY A SOLAR CELL, AND METHOD FOR THE PRODUCTION THEREOF
COMPOSANT A SEMI-CONDUCTEUR, NOTAMMENT PILE SOLAIRE ET PROCEDE PERMETTANT DE L'OBTENIR

(30) Priorität: 29.04.1998 EP 98810382
(43) Veröffentlichungstag der Anmeldung: 06.09.2000
(73) Patentinhaber: La Vecchia, Nunzio, Dr., 6612 Ascona (CH)
(72) Erfinder: La Vecchia, Nunzio, Dr., 6612 Ascona (CH)
(74) Vertreter: Luchs, Willi
(86) Internationale Anmeldenummer: PCT/CH1998/000455
(87) Internationale Veröffentlichungsnummer: WO 1999/056325

(56) Entgegenhaltungen:
- US-A- 4 589 918
- US-A- 4 649 227
- BLENK O.: "P-type conduction in pyrite single crystals prepared by chemical vapor transport" APPLIED PHYSICS LETTERS, Bd. 62, Nr. 17, 26. April 1993, Seiten 2093-2095, XP002086745
- ENNAOUI A ET AL: "IRON DISULFIDE FOR SOLAR ENERGY CONVERSION" SOLAR ENERGY MATERIALS AND SOLAR CELLS, Bd. 29, Nr. 4, 1. Mai 1993, Seiten 289-370, XP000361625

## Beschreibung

Die Erfindung betrifft ein Halbleiterbauelement, insbesondere eine Solarzelle, *nach dem Oberbegriff des Anspruches 1, sowie Verfahren zu dessen Herstellung*.

Es sind bereits eine Anzahl gattungsmässiger Halbleiterbau- oder Halbleiterphotoelemente bekannt, mittels welchen durch Ausnutzung des inneren Photoeffektes Strahlungsenergie der Sonne oder von Licht bei einem Wirkungsgrad bis annähernd 15 % eine kommerzielle Nutzung erfolgt. Als Halbleitermaterialien werden vorwiegend dünne Silizium- oder Galliumarsenid-Einkristalle mit p- und n-leitenden Zonen verwendet.

Es sind auch Dünnschicht-Solarzellen bekannt, bei welchen die Halbleiterschichten auf einen Träger mittels Aufdampfen oder ähnlichem mit einer Stärke im Mikrometerbereich (1 bis 50µm) aufgebracht werden. Hierzu werden für diese Halbleiterschichten Materialien, wie Cadmiumsulfid, Cadmiumtellurid, Kupfersulfid oder ähnliche verwendet. Mit diesen Halbleiterbauelementen wird jedoch nur ein Wirkungsgrad von ca. 5 - 8% erreicht. Sie weisen aber ein günstiges Leistungsgewicht auf und sind gegenüber den Silizium-Einkristallen wesentlich günstiger herstellbar.

Bei einer gattungsmässigen Solarzelle nach der Druckschrift EP-A 0 173 642 ist eine photoaktive Pyritschicht entsprechend der Formel FeS₂ vorgesehen, welche eine Konzentration an unerwünschten Verunreinigungen von < 10²⁰ pro cm³ und eine Dotierung mit Mangan (Mn) oder Arsen (As) bzw. Kobalt (Co) oder Chlor (Cl) aufweist.

In einer Publikation, "Iron disulfide for solar energy conversion" aus Solar Energy Materials and Solar Cells vom Mai 1993, ist Pyrit als Solarenergie-Material untersucht worden, bei dem Pyrit als ultradünne Schicht (10 - 20 nm) zwischen zwei p-Typ und n-Typ Materialien eingebettet worden ist.

In der Veröffentlichung (Applied Physics Letters vom 26.4.1993, Seiten 2093-2095 von BLENK. O.) wird von einem Halbleiter-Basismaterial aus kleinen Pyrit-Kristallen FeS₂ ausgegangen. Zu den Elementen Fe und S wird Phosphor hinzugefügt, namentlich rotes Phosphor in einer Konzentration von 0,5 bis 4,0 Gewichtsprozenten. Durch die Verwendung von Pyrit und der Dotierung respektive Züchtung dieses Pyrits mit Phosphor wurden gewisse elektrische Eigenschaften nachgewiesen.

Mit diesem Halbleiterbauelement sollen die Herstellungskosten so niedrig sein, dass eine aus diesem hergestellte Solarzelle sich u.a. für Massenartikel eignet. Ein weiteres Ziel der Erfindung besteht ausserdem darin, ein Halbleitermaterial zu verwenden, welches leicht und umweltschonend entsorgt werden kann.

Die Aufgabe ist erfindungsgemäss durch die Merkmale des Anspruches 1 gelöst.

Mit diesem erfindungsgemässen Halbleiterbauelement lassen sich Solarzellen herstellen. Das als Halbleitermaterial verwendete Pyrit hat den Vorteil, dass es als natürliches Material vorkommt oder dass es sich auch synthetisch herstellen lässt.

Ausführungsbeispiele der Erfindung sowie weitere Vorteile derselben sind nachfolgend anhand der Zeichnung näher erläutert. Es zeigt:
- Fig.1: einen schematischen Querschnitt durch ein erfindungsgemässes Halbleiterbauelement in vergrösserter Darstellung,
- Fig.2: eine schematische Darstellung der Energieaufspaltung der Fe d-Zustände im oktraedischen und verzerrt oktraedischen Ligandenfeld des Pyrit,
- Fig.3: einen schematischen Querschnitt durch ein erfindungsgemässes Halbleiterbauelement mit einem Heteroübergang in vergrösserter Darstellung, und
- Fig.4: eine schematische Darstellung der Energiebänder bei einem Heteroübergang.

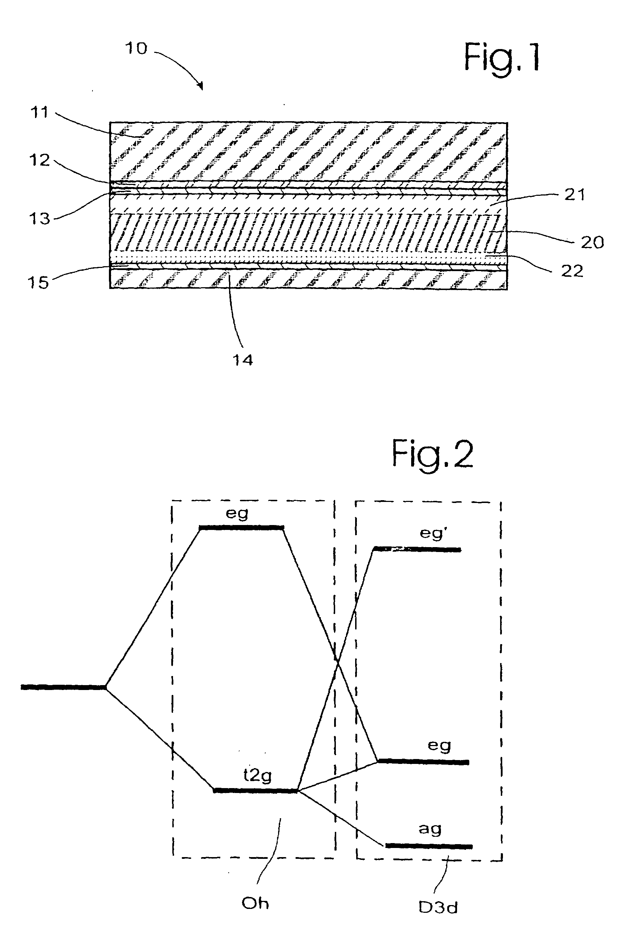

Fig.1 zeigt schematisch ein erfindungsgemässes Halbleiterbauelement 10, welches insbesondere als Solarzelle ausgebildet ist. Dieses Halbleiterbauelement 10 besteht im vorliegenden Ausführungsbeispiel aus einer mehrschichtigen Struktur und es kann beispielsweise zusammen mit einer Anzahl von nebeneinander angeordneten Zellen in einem als Panel ausgebildeten Metallgehäuse eingekapselt sein, was nicht im Detail dargestellt ist. Die Solarzelle weist vorzugsweise eine Abdeckplatte mit einem durchsichtigen Werkstoff, z.B. einer Glasschicht 11 oder ähnlichem auf, hierdurch diese Zelle gegen mechanische Krafteinwirkungen, wie Schläge etc., gegen Feuchtigkeit und/oder Witterungseinflüsse generell geschützt ist. Eine Laminatschicht 12, bspw. aus Harz, umschliesst zusammen mit einem auf der Unterseite angeordneten, z.B. als Keramikplatte ausgebildeten Isolator 14 die Solarzelle, damit das Innere der Solarzelle abgeschlossen und demnach undurchlässig gegen Feuchtigkeit, Wasser oder dergleichen ist.

Erfindungsgemäss besteht das Halbleiter-Basismaterial 20 aus Pyrit oder Eisenkies, welches eine chemische Zusammensetzung von FeS₂ hat. Das Halbleiter-Basismaterial 20 ist wenigstens mit Bor und Phosphor verbunden oder dotiert, wobei im gezeigten Beispiel das Halbleiter-Basismaterial aus der einen FeS₂ - Schicht 20 besteht.

Dieses als Festkörperzelle ausgebildete Halbleiterbauelement 10 setzt sich aus dem aus reinstem Pyrit einschichtig erzeugten Halbleiter-Basismaterial 20, einer Schicht Phosphor 21 und einer Schicht Bor 22 zusammen. Diese Schicht Phosphor 21 und diese Schicht Bor 22 sind hierbei derart auf die entsprechenden Oberflächen der Pyritschicht 20 aufgetragen, dass zwischen dem Halbleiterbasismaterial und dem Phosphor (P) bzw. dem Bor (B) eine Verbindung im Sinne einer Dotierung hergestellt ist. Vorzugsweise sind diese Schichten Phosphor 21 und Bor 22 jeweils in einer sehr dünnen Dicke von einigen Mikrometern durch ein nachfolgend erläutertes Verfahren aufgetragen.

Hieraus ergibt sich die gewünschte Funktionsweise dieses als Solarzelle vorgesehenen Halbleiterbauelementes 10, mittels welchem bei Sonnenlichteinstrahlung ein elektrischer Strom erzeugt wird, der zweckmässigerweise an den ober- und unterhalb der Halbleiterschichten angeordneten Leitermaterialien 13 und 15 in an sich bekannter Weise abgegriffen wird, wobei das Leitermaterial 15 vom Isolator 14 abgeschirmt ist. Diese Leitermaterialien sind über nicht näher gezeigte Leitungen mit einem Verbraucher oder dergleichen verbunden.

Fig.1 ist als Solarzelle mit einem im Rahmen der Erfindung einfachen Strukturaufbau dargestellt. Selbstverständlich könnten auch sowohl die Leitermaterialien als auch die Halbleiterschicht in unterschiedlicher Konfiguration und Anzahl vorgesehen sein.

Ein solches Halbleiterbauelement kann als Solarzelle für die verschiedensten Ausführungen verwendet werden, sei es für sehr kleine Zellen, bspw. für Taschenrechner, als auch für Solarzellen zur Heizung von Häusern und für Grossanlagen, mittels welchen insbesondere die Sonnenenergie in elektrischen Strom umgewandelt wird.

Bei Pyrit oder Eisenkies als natürlich vorkommendes Gestein handelt es sich um das meistverbreitete Sulfid auf der Erde, welches beispielsweise in Spanien als hydrothermal entstandenes Erzgebiet existiert. Die einzelnen Kristalle des Pyrits sind messing- oder mörtelfarbig und sehr hart, deren Mohs'sche Härte ca. 6 bis 6.5 beträgt. Pyrit hat einen thermischen Ausdehnungskoeffizienten bei 90 bis 300 K von 4.5x10⁻⁶ K⁻¹ und bei 300 bis 500 K von 8.4x10⁻⁶ K⁻¹. Der die chemische Zusammensetzung FeS₂ aufweisende Pyrit hat eine Elementarzelle von 12 Atomen und eine Länge der Einheitszelle von annähernd 5.4185 Angström (1 Angström = 0.1 nm). Die typischen Grundformen des Kristallhabitus des Pyrits treten als Würfel, als kubische Form, als Pentagondodekaeder oder als Oktaeder auf. Ein weiterer Vorteil dieses Halbleiterbauelementes besteht darin, als dieser Pyrit eine gute Umweltverträglichkeit aufweist.

Mit Bezug auf die Wirkungsweise dieser erfindungsgemässen Solarzelle 10 werden nach den allgemein gültigen Regeln der Quantenmechanik nur solche Lichtquanten wirksam, deren Energie mindestens gleich der Breite der verbotenen Zone und höchstens gleich der Energiedifferenz zwischen unterer Kante des Valenzbandes und oberer Kante des Leitungsbandes ist. Die Menge der erzeugten Ladungsträger im Halbleiter hängt neben der Energie und der Anzahl pro Flächeneinheit der eingestrahlten Photonen vom Absorbtionskoeffizienten a des Halbleiters ab. Pyrit verfügt im Vergleich zu herkömmlichen Halbleitermaterialien über einen sehr hohen Absorptionskoeffizienten, welcher bei der Bandkante bei α > 10⁵ cm⁻¹ für λ < 1µm liegt. Mit der Ausbildung des Halbleiterbauelementes 10 nach der Erfindung hat man sich diese Eigenschaft des Pyrits vollauf zu Nutze gemacht.

Gemäss Fig.2 ist die Energieaufspaltung der Fe d-Zustände im oktraedischen Oₕ und verzerrt oktraedischen D_{3d} Ligandenfeld ersichtlich. Es wird hierbei eine Bandlücke des Halbleiter-Basismaterials durch die Aufspaltung der Fe d-Zustände in besetzte t_{2g}- und unbesetzte e_{g}-Zustände gebildet, wobei diese Bandlücke bis 0.7 eV oder mehr beträgt. Das Valenzband hat eine Breite von 0.8 eV oder mehr und die darunter liegende Gruppe ist durch eine Lücke von ebenfalls ca. 0.8 eV getrennt. Die Zustände oberhalb des Leitungsbandes haben ihren Ursprung in Fe 4s und 4p Zuständen. Im Bereich der Molekülorbitaltheorie wird die Energielücke bei Pyrit durch das Aufspalten der 3d-Zustände des Eisens in energetisch nieder besetzte t_{2g}- und unbesetzte e_{g}-Zustände erzeugt. Die Aufspaltung wird durch das oktraedische Ligandenfeld des Schwefels verursacht, das leicht verzerrt ist und zu einer weiteren, hier jedoch unwesentlichen Aufspaltung der Energieniveaus führt.

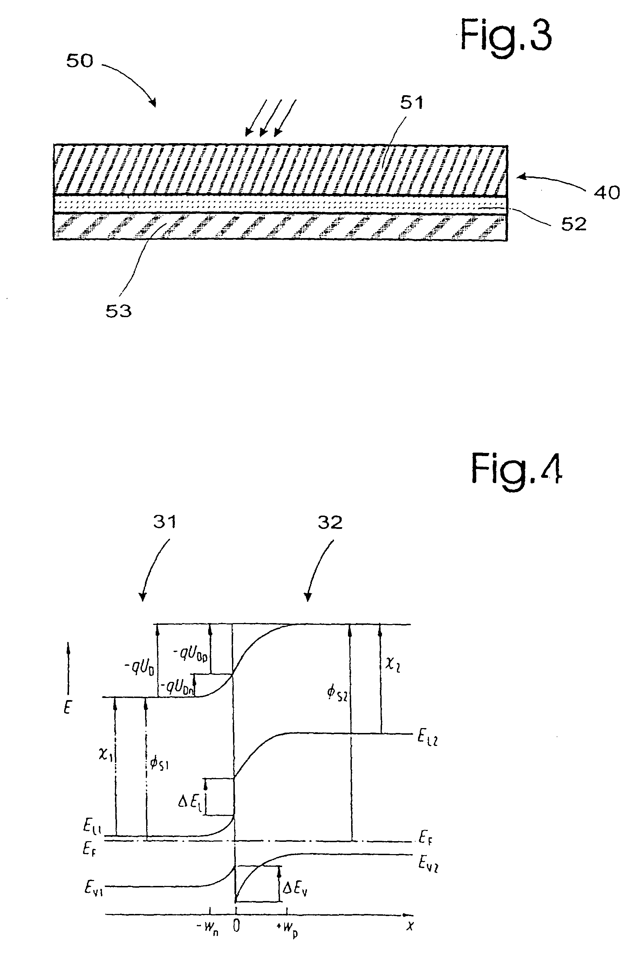

Fig.3 zeigt wiederum in schematischer Darstellung einen Querschnitt eines erfindungsgemässen Halbleiterbauelementes 50, welches aus wenigstens einer oberen Schicht Pyrit 51, welches das Halbleiterbasismaterial 40 bildet, einer Schicht Bor 52 und aus einer Schicht Phosphor 53 zusammengefügt ist. Der Pyrit 51 ist hierbei auf der Oberseite angeordnet, bei welcher die einwirkende Sonneneinstrahlung oder dergleichen als erste aufgenommen werden. Bei dieser Anordnung der Schichten ist erfindungsgemäss wiederum eine Verbindung bzw. ein Einbau des Phosphors 53 und des Bors 52 mit dem bzw. in das angrenzende Basismaterial Pyrit 51 erzeugt. Die Leiterelemente können derart angeordnet sein, dass sie die Schichten 51, 52, 53 entsprechend abgreifen, was nicht näher dargestellt ist.

Im Unterschied zu dem in Fig.3 schichtweise hergestellten Halbleiter-Basismaterial 40 könnten eine oder mehrere Schichten Bor und eine oder mehrere Schichten Phosphor quer in der zum Beispiel als Einkristall erzeugten Pyrit-Targets angeordnet sein.

Die Halbleiter-Basismaterialien 20 bzw. 40 zu diesen erfindungsgemässen Solarzellen 10, 50 können auf verschiedene Arten hergestellt werden. Der Pyrit in der Zusammensetzung von FeS₂ kann entweder aus natürlichem Vorkommnis gewonnen oder aus Eisen und Schwefel synthetisch hergestellt oder gezüchtet werden.

Bei der Verwendung von natürlichen Pyritkristallen als Halbleiter-Basismaterial 20 muss dieses Pyrit, welches eine Nettoladungsträgerkonzentration von ca. 10¹⁵ cm⁻³ hat, in an sich bekannter Weise mehrfach zonengereinigt werden, damit es einen definierten Reinheitsgrad erreicht. Ebenso sind die Verbindungs- bzw. Dotiermaterialien Phosphor und Bor ebenfalls mit höchstem Reinheitsgrad zu versehen, um aus diesen die erfindungsgemässen Zellen in höchster Güte herstellen zu können.

Für die künstliche Herstellung oder Züchtung des Halbleiter-Basismateriales Pyrit sind verschiedene Methoden anwendbar, wobei die Ausgangsmaterialien ebenfalls bereits durch eine Mehrfach-Zonenreinigung behandelt sind, um eine höchstmögliche Reinheit nach der chemischen Verbindung derselben zu erreichen.

Als Herstellungsmethode eignet sich u.a. der Gasphasentransport (CVT), bei dem der Temperaturgradient beim Erzeugen der Eisen-Schwefelverbindung zwischen 250° und 1200°C liegen soll. Wenn Pyrit als natürliches Ausgangsmaterial verwendet wird, kann auf der kälteren Seite die Temperatur zwischen 250° und 850°C variieren. Als Transportmittel für die Beschickung von Schwefel im Eisen kann beispielsweise Brom (Br_{2,} FeBr₃) oder ein anderer Werkstoff genommen werden.

Die Kristallzucht erfolgt beispielsweise in einer Natriumpolysulfid-Lösung. Das Pyrit lässt sich aus den gereinigten Ausgangselementen Eisen und Schwefel neben dem Standardtemperaturgradienten zwischen 250° und 1200°C auch in einem Gradienten von 200° bis 1400°C züchten. Diese CVT-Methode bietet eine erhöhte Reproduzierbarkeit bei der Herstellung und es können mit ihr absolut reine Kristalle erzeugt werden.

Bei der Erzielung von grossen einkristalligen Pyritstücken wird vorzugsweise das Herstellungsverfahren via Schmelzlösung mit Tellur, BrCl₂. Na,S₂ oder ähnliche Materialien verwendet.

Eine weitere Herstellungsvariante von Pyrit besteht in dem RF-Sputtern. Dies erfolgt in einer Sputteranlage, bei der ein Pyrittarget mit einem Argon-Schwefel-Plasma gesputtert wird. Der Argonfluss beträgt in der Regel zwischen 0.1 und 300 ml/min und der Schwefel wird durch das Verdampfen von elementarem Schwefel beigesetzt. Beim Abscheiden ist der Arbeitsdruck von 0.01 mbar oder mehr oder auch weniger gehalten worden. Das verwendete Self-Bias-DC-Potential ist auf 0 bis 400 Volt eingestellt. Die Substrattemperatur ist von 80° bis 950°C gewählt worden. Mit diesem Verfahren kann grundsätzlich auch ein Poly-Kristallgefüge erzeugt werden.

Zur Herstellung von erfindungsgemässen Halbleiterbauelementen als Dünnfilme kann man ein inkongruentes Materialsystem verwenden. Es eignet sich das reaktive Sputtern von einem Target aus Pyrit, die MOCVD-Methode und die Spray-Pyrolyse. Ausserdem kann mittels der Methode des thermischen Verdampfens mit Hilfe eines Fördersystems, welches ständig kleine Mengen von einem Pulvergemisch in die heisse Verdampfungsquelle einbringt, gewährleistet werden, dass das Material, bedingt durch die hohe Temperatur nahezu vollständig verdampft. Bei dieser Art des Verdampfens ergibt sich der Vorteil, dass auf die Stöchiometrie und eine mögliche Dotierung Einfluss genommen werden kann, da man z.B. den Dotierstoff direkt zum Pulvergemisch zugeben kann. Bei einer Sulferisierung von Eisenfilmen, sei es nun rein thermisch oder mit Hilfe eines Plasmas, ist es möglich, von sehr reinen Ausgangsmaterialien auszugehen.

Die Dicke der aktiven Schicht hat einen grossen Einfluss auf den Wirkungsgrad der Solarzelle. Zur Abschätzung des Wirkungsgrades und der dafür erforderlichen Zellenparameter lassen sich entsprechende Grenzbereiche festlegen.

Für die Dotierung oder die Verbindung des Halbleiter-Basismateriales mit Phosphor und Bor werden letztere vorzugsweise in einem Massen-Prozentsatz von 10⁻⁶ bis 20 % des Basismaterials verwendet. Dies hängt von den angestrebten Eigenschaften des gefertigten Halbleiterbauelementes ab.

Das erfindungsgemässe Halbleiterbauelement könnte auch als sogenannte Tandemzelle gefertigt sein. Hierbei könnte beispielsweise eine dotierte Schicht aus Pyrit und eine weitere p- und n-Schicht aus einem anderen Halbleiterkristall, wie zum Beispiel aus Silizium, aus Galliumasenid oder aus einem anderen wählbaren Material zusammenwirken. Mit einem solchen Halbleiterbauelement könnte eine maximale Ausnutzung des Sonnenspektrums erreicht werden, wenn mit diesen unterschiedlichen Halbleiter-Basismaterialien eine Abdeckung der Energielücke zwischen 1,0 und 1,8 eV erfolgen würde.

Gemäss Fig.4 können auch Heteroübergänge zwischen unterschiedlichen Halbleitermaterialien benutzt werden, wie dies bereits oben zu der Ausführungsvariante gemäss Fig.3 ausführlich erläutert ist. Voraussetzung hierfür ist jedoch, dass die Gitterkonstanten und deren thermische Ausdehnungskoeffizienten beider Stoffe nicht zu stark voneinander abweichen. Als Beispiel könnte ein p-Halbleiter 31 aus Pyrit mit einem n-leitenden Halbleiter 32 aus einem andern Material kombiniert werden. Mit diesem Heteroübergang ist eine Banddiskoniuität herbeigeführt worden, mit Hilfe derer in einer neuartigen Weise auf den Ladungsträgertransport eingewirkt werden kann. Mit den beiden getrennten Halbleitermaterialien 31 und 32 sind die Bandlükken E_{G}, die Austrittsarbeiten φₛ sowie die Elektronenaffinitäten χ unterschiedlich.

Für die Herstellung von Heteroübergängen sind speziell entwickelte Epitaxieverfahren bekannt, welche auch mit Bezug auf die in der vorliegenden Erfindung verwendeten Halbleiter-Basismaterialien benutzt werden. Zum einen gibt es die Molekularstrahlepitaxie (MBE) und zum andern die Gasphasenepitaxie (MOCVD) in der Form der Gasphasenabscheidung aus metall-organischen Verbindungen.

Bei der Dünnfilm-Solarzelle mit einem Heteroübergang werden Phosphor und Bor vorzugsweise durch eine Ionenimplantation in die Oberfläche des Halbleiterbasismateriales Pyrit eingebaut oder dotiert, die mit Hilfe von Teilchenbeschleunigern erfolgt. Dabei werden die Dotieratome nach der Ionisierung auf eine hohe Energie gebracht und in das Basismaterial geschossen, in welcher sie nach einer charakteristischen Eindringtiefe abgebremst werden und in dieser verbleiben. Bei dieser Implantationsprozess wird das Gitter des Halbleiterkristalls erheblich geschädigt und es muss durch eine thermische Behandlung regeneriert werden. Dabei diffundieren die implantierten Störstellen und werden gleichzeitig ins Gitter eingebaut. Demgemäss bilden sich Mischprofile aus Ionenimplantation und Störstellendiffussion.

Beim Molekularstrahlepitaxie-Verfahren (MBE) handelt es sich um ein spezielles Aufdampfverfahren. Das Verdampfungsmaterial wird in geheizten zylinderförmigen Röhren mit einer kleinen Öffnung an der Stirnseite verdampft. Die Grösse dieser Öffnung und der durch Heizung eingestellte Dampfdruck in den Öfen bestimmen den Materialtransport zum Target. Ultrahochvakuum kontrolliert mit einem Massenanalysator sowie gekühlte Abschirmbleche lassen sehr saubere Kristallschichten entstehen. Die Struktur dieser Kristallschichten kann durch sogenannte RHEED-Messungen (Reflected High Energy Electron Diffraction) quasi online kontrolliert und deren Schichtdicke durch eine Temperaturregelung und schnelle Verschlüsse auf eine Atomlage genau eingestellt werden.

Das Halbleiterbauelement kann bei einer mehrschichtigen Struktur bis zu annähernd hundert Schichten aufweisen. So wäre beipsielsweise denkbar, dass das Halbleiterbauelement nach der Fig.3 aus mehr als drei unterschiedlichen Schichten gebaut sein könnte, so zum Beispiel könnten mehrere Schichten aus Pyrit und gegebenenfalls auch mehrere Schichten aus Bor bzw. Phosphor vorhanden sein.

Das als Pyrit verwendete Halbleiterbauelement lässt sich - wie oben bereits erwähnt - im Rahmen der Erfindung nicht nur als Ein- oder Mehrschicht-Festkörper-Solarzelle, sondern auch als Dünnfilm-Solarzelle, als MIS-Solarzelle, als photochemische Zelle oder dergleichen ausbilden.

Sehr vorteilhaft wird das Halbleiterbauelement nach der Erfindung als Solarzelle genutzt. Selbstverständlich könnte dieses Halbleiterbauelement auch für andere Zwecke, wie beispielsweise als Diode, Transistor, Thyristor oder dergleichen verwendet werden.

## Patentansprüche

1. Halbleiterbauelement, insbesondere eine Solarzelle, mit mindestens einem aus einem Mono- oder einem Poly-Kristallgefüge bestehenden Halbleiter-Basismaterial (20, 40), welches zumindest teilweise aus Pyrit mit der chemischen Zusammensetzung FeS₂ besteht und zur Erzielung eines definierten Reinheitsgrades gereinigt ist, **dadurch gekennzeichnet, dass** das zumindest teilweise aus Pyrit in der chemischen Zusammensetzung FeS₂ bestehende Halbleiter-Basismaterial (20, 40) wenigstens mit Bor (52) und Phosphor (53) verbunden oder dotiert ist.

2. Halbleiterbauelement nach Anspruch 1, **dadurch gekennzeichnet, dass** bei einem mehrschichtigen Halbleiter-Basismaterial wenigstens eine p- oder n-Schicht aus Pyrit (31) und wenigstens eine n- oder p-Schicht aus einem andern Halbleiter (32) vorgesehen ist.

3. Halbleiterbauelement nach einem der vorhergehenden Ansprüche, **dadurch gekennzeichnet, dass** die Konzentration der in das HalbleiterBasismaterial (20, 40) eingebauten Elemente jeweils zwischen 10⁻⁶ und 20 Massen-Prozente beträgt.

4. Halbleiterbauelement nach einem der vorhergehenden Ansprüche, **dadurch gekennzeichnet, dass** das Halbleiter-Bauelement als Ein- oder Mehrschicht-Solarzelle, als Dünnfilm-Solarzelle, als MIS-Solarzelle *oder* als photochemische Zelle ausgebildet ist.

5. Halbleiterbauelement nach einem der vorhergehenden Ansprüche, **dadurch gekennzeichnet, dass** der Pyrit einen thermischen Ausdehnungskoeffizienten bei 90 bis 300 K von 4.5x10⁻⁶ K⁻¹ und bei 300 bis 500 K von 8.4x10⁻⁶ K⁻¹ aufweist.

6. Halbleiterbauelement nach einem der vorhergehenden Ansprüche, **dadurch gekennzeichnet, dass** der die chemische Zusammensetzung FeS₂ aufweisende Pyrit eine Elementarzelle von 12 Atomen und eine Länge der Einheitszelle von annähernd 5.4185 Angström (1 Angström = 0.1nm) hat, wobei die Grundformen des Kristallhabitus des Pyrits als Würfel, als kubische Form, als Pentagondodekaeder oder als Oktaeder auftreten.

7. Halbleiterbauelement nach einem der vorhergehenden Ansprüche, **dadurch gekennzeichnet, dass** das aus Pyrit gebildete Halbleiter-Basismaterial mehrfach zonengereinigt ist.

8. Halbleiterbauelement nach einem der vorhergehenden Ansprüche, **dadurch gekennzeichnet, dass** das Halbleiterbauelement bei einer mehrschichtigen Struktur bis zu annähernd hundert Schichten aufweist.

9. Verfahren zur Herstellung eines Halbleiterbauelementes, insbesondere einer Solarzelle, nach einem der vorhergehenden Ansprüche, **dadurch gekennzeichnet, dass**
für das Halbleiter-Basismaterial entweder ein natürlich vorkommender oder ein aus Eisen und Schwefel synthetisch hergestellter Pyrit in der chemischen Zusammensetzung FeS₂ verwendet wird, das wenigstens mit Bor (52) und Phosphor (53) verbunden oder dotiert wird.

10. Verfahren nach Anspruch 10, **dadurch gekennzeichnet, dass** das Pyrit bzw. die Ausgangsmaterialien Eisen und Schwefel bei synthetisch hergestelltem Pyrit zur Erzielung eines hohen Reinheitsgrades mehrfach zonengereinigt sind.

11. Verfahren nach Anspruch 11, **dadurch gekennzeichnet, dass** das Pyrit durch eine Hydrothermal-Methode, durch eine nass-chemische Methode (CVT) hergestellt wird.

12. Verfahren nach Anspruch 10, **dadurch gekennzeichnet, dass** das Pyrit durch eine Tellur-, eine NaS₂- oder FeCl₂ Schmelze-Methode hergestellt wird.

13. Verfahren nach Anspruch 10, **dadurch gekennzeichnet, dass** das Pyrit durch die Methode eines Gasphasentransportes hergestellt und/oder dotiert wird.

14. Verfahren nach Anspruch 14, **dadurch gekennzeichnet, dass** beim Gasphasentransport das Transportmittel Br₂ verwendet wird.

15. Verfahren nach Anspruch 10, **dadurch gekennzeichnet, dass** die Herstellung des Pyrit über eine Plasmasulfidation, eine thermische Sulfidation, ein MOCVD-Verfahren, reaktives Sputtern oder Spray-Pyrolyse erfolgt.

16. Verfahren nach Anspruch 10, **dadurch gekennzeichnet, dass** das Bor und/oder das Phosphor durch ein Epitaxieverfahren mit dem Basismaterial Pyrit verbunden oder dotiert werden.

17. Verfahren nach Anspruch 10, **dadurch gekennzeichnet, dass** das Bor und/oder das Phosphor durch ein Ionenimplantationsverfahren mit dem Basismaterial-Pyrit verbunden oder dotiert werden.

## Claims

1. Semiconductor component, in particular a solar cell, with at least one semiconductor base material (20, 40) consisting of a mono or a polycrystalline structure, which consists at least in part of pyrite with the chemical composition FeS₂ and which is cleaned for the purpose of achieving a defined degree of purity, **characterised in that** the semiconductor base material (20, 40) at least in part of pyrite with the chemical composition FeS₂ is combined or doped with boron (52) and phosphorous (53).

2. Semiconductor component in accordance with Claim 1, **characterised in that** in a multilayer semiconductor base material consists at least one p- or n-layer of pyrite (31), and at least one n- or p-layer provided to be of another semiconductor component.

3. Semiconductor component in accordance with one of the above Claims, **characterised in that** the concentration of each of the elements integrated into the base material has a mass percentage of between 10⁻⁶ and 20.

4. Semiconductor component in accordance with one of the above Claims, **characterised in** the semiconductor component is created as a single or multilayer solar cell, as thin film solar cell, as MIS solar cell or as photo-chemical cell or similar.

5. Semiconductor component in accordance with one of the above Claims, **characterised in that** the pyrite has a thermal expansion coefficient at 90 to 300 K of 4.5x10⁻⁶ K⁻¹ and at 300 to 500 K, of 8.4x10⁻⁶ K⁻¹.

6. Semiconductor component in accordance with one of the above Claims, **characterised in that** pyrite with the chemical composition FeS₂ has an elementary cell of 12 atoms and the unit cell has a length of approximately 5.4185 Angstroms (1 Angstrom = 0.1nm), whereby the basic forms of the crystal habitus of the pyrite occur as a hexahedral, a cubic shape, a pentagonal dodecagon or an octahedron.

7. Semiconductor component in accordance with one of the above Claims, **characterised in that** semiconductor base material created from pyrite is treated by a multi-zone cleaning process.

8. Semiconductor component in accordance with one of the above Claims, **characterised in that** in the case of a multi-layered structure, the semiconductor component can have up to one hundred layers.

9. Method of producing a semiconductor component, in particular a solar cell, in accordance with one of the above claims, **characterised in that** for the semiconductor base material, either a naturally occurring pyrite or a pyrite synthesised from iron and sulphur, with the chemical composition FeS₂ is used, which is combined or doped with boron (52) and phosphorous (53) respectively.

10. Method in accordance with Claim 10, **characterised in that** the pyrite and/or the base materials of iron or sulphur, given that the pyrite is produced synthetically, are treated by a multi-zone cleaning process for the purpose of achieving a high degree of purity.

11. Method in accordance with Claim 11, **characterised in that** the pyrite is produced by a hydro-thermal process and by a wet chemical process (CVT).

12. Method in accordance with Claim 11, **characterised in that** the pyrite is produced by a process which fuses telluride, NaS₂ or FeCl₂.

13. Method in accordance with Claim 10, **characterised in that** the pyrite is produced and / or doped by the gaseous phase transport method.

14. Method in accordance with Claim 14, **characterised in that** transport medium Br₂ is used for the gaseous phase transport.

15. Method in accordance with Claim 10, **characterised in that** the pyrite is produced by plasma sulphurisation, a thermal sulphurisation, a MOCVD process, reactive sputtering, spray pyrolysis or by a different process.

16. Method in accordance with Claim 10, **characterised in that** the boron and/or the phosphorus get connected or doped by an epitaxie-process with the basis material pyrite.

17. Method in accordance with Claim 10, **characterised in that** the boron and/or the phosphorus get connected or doped by an ionic-implantation-method with the basis material pyrite.

## Revendications

1. Composant semi-conducteur, en particulier cellule solaire, comportant au moins un matériau de base semi-conducteur (20, 40) ayant une structure monocristalline ou polycristalline, lequel matériau est constitué au moins partiellement de pyrite de composition chimique FeS₂ et est purifié à un degré de pureté défini, **caractérisé en ce que** le matériau de base semi-conducteur (20, 40) constitué au moins partiellement de pyrite de composition chimique FeS₂ est lié ou dopé au moins avec du bore (52) et du phosphore (53).

2. Composant semi-conducteur selon la revendication 1, **caractérisé en ce qu'**il est prévu dans un matériau de base semi-conducteur multicouche au moins une couche p ou n de pyrite (31) et au moins une couche n ou p d'un autre semi-conducteur (32).

3. Composant semi-conducteur selon l'une des revendications précédentes, **caractérisé en ce que** la concentration en éléments incorporés dans le matériau de base semi-conducteur (20, 40) est comprise entre 10⁻⁶ et 20% en poids.

4. Composant semi-conducteur selon l'une des revendications précédentes, **caractérisé en ce que** le composant semi-conducteur est conformé en cellule solaire monocouche ou multicouche, en cellule solaire en couche mince, en cellule solaire MIS ou bien en cellule photochimique.

5. Composant semi-conducteur selon l'une des revendications précédentes, **caractérisé en ce que** la pyrite présente un coefficient de dilatation thermique de 4,5 x 10⁻⁶ K⁻¹ à une température comprise entre 90 et 300 K, et de 8,4 x 10⁻⁶ K⁻¹ à une température comprise entre 300 à 500 K.

6. Composant semi-conducteur selon l'une des revendications précédentes, **caractérisé en ce que** la pyrite de composition chimique FeS₂ présente une cellule élémentaire de 12 atomes et d'une longueur d'environ 5,4185 Å (1 Å = 0,1 mm), la forme caractéristique du cristal de pyrite étant celle d'un hexaèdre, d'une cube, d'un dodécaèdre pentagonal ou d'un octaèdre.

7. Composant semi-conducteur selon l'une des revendications précédentes, **caractérisé en ce que** le matériau de base semi-conducteur constitué de pyrite est purifié plusieurs fois par zones.

8. Composant semi-conducteur selon l'une des revendications précédentes, **caractérisé en ce que** la structure multicouche du composant semi-conducteur comporte jusqu'à environ 100 couches.

9. Procédé de fabrication d'un composant semi-conducteur, en particulier d'une cellule solaire, selon l'une des revendications précédentes, **caractérisé en ce que** l'on utilise pour le matériau de base semi-conducteur une pyrite d'origine naturelle ou d'origine synthétique constituée de fer et de soufre de composition chimique FeS₂, laquelle pyrite est liée ou dotée avec au moins du bore (52) et du phosphore (53).

10. Procédé selon la revendication 10, **caractérisé en ce que**, dans le cas d'une pyrite de synthèse, la pyrite respectivement les matériaux de départ fer et soufre sont purifiés plusieurs fois par zones à un degré de pureté élevé.

11. Procédé selon la revendication 11, **caractérisé en ce que** la pyrite est fabriquée par un procédé hydrothermal, par un procédé chimique par voie humide.

12. Procédé selon la revendication 10, **caractérisé en ce que** la pyrite est fabriquée par un procédé de fusion de tellure, de NaS₂, ou de FeCl₂.

13. Procédé selon la revendication 10, **caractérisé en ce que** la pyrite est fabriquée et/ou dopée par les procédés de transfert en phase gazeuse.

14. Procédé selon la revendication 14, **caractérisé en ce que** l'on utilise dans le transfert en phase gazeuse le vecteur Br₂.

15. Procédé selon la revendication 10, **caractérisé en ce que** la fabrication de la pyrite est réalisée par une procédé de sulfuration par plasma, de sulfuration par voie thermique, MOCVD, de pulvérisation réactive ou de pyrolyse par pulvérisation.

16. Procédé selon la revendication 10, **caractérisé en ce que** le bore et le phosphore sont liés ou dopés par un procédé d'épitaxie avec le matériau de base pyrite.

17. Procédé selon la revendication 10, **caractérisé en ce que** le bore et le phosphore sont liés ou dopés par un procédé d'implantation ionique avec le matériau de base pyrite.
